# EUROPÄISCHE PATENTSCHRIFT

(11) **EP 2 844 475 B1**
(45) Veröffentlichungstag und Bekanntmachung des Hinweises auf die Patenterteilung: **22.01.2020**
(21) Anmeldenummer: 13714851.6
(22) Anmeldetag: 21.03.2013
(51) Int. Cl.: B41F 23/04, F21K 99/00, H01L 25/075, H01L 33/54

(54) **OPTISCHES MODUL MIT AUSFORMUNG ZUR MONTAGE**
OPTICAL MODULE COMPRISING A MOLDED PORTION FOR INSTALLATION
MODULE OPTIQUE À PARTIE SAILLANTE CONÇUE POUR LE MONTAGE

(30) Priorität: 02.05.2012 DE 102012008637
(43) Veröffentlichungstag der Anmeldung: 11.03.2015
(73) Patentinhaber: Heraeus Noblelight GmbH, 63450 Hanau (DE)
(72) Erfinder: PEIL, Michael, 64853 Otzberg (DE); SCHADT, Susanne, 63505 Langenselbold (DE); MAIWEG, Harald, 41352 Korschenbroich (DE); HELMLING, Marcus, 64732 Bad König (DE)
(74) Vertreter: Heraeus IP
(86) Internationale Anmeldenummer: PCT/EP2013/000862
(87) Internationale Veröffentlichungsnummer: WO 2013/164054

(56) Entgegenhaltungen:
- EP-A1- 2 317 205
- EP-A1- 2 388 139
- WO-A1-2008/152575
- WO-A1-2012/031703
- US-A- 5 660 461

## Beschreibung

Die Erfindung betrifft allgemein ein optisches Modul, insbesondere umfassend ein Substrat von definierter Form, wobei das Substrat zwei gegenüberliegende Oberflächen und einen Rand aufweist, und eine auf zumindest einer der Oberflächen überdeckend aufgebrachte Schicht, wobei die Schicht aus einem transparenten, polymeren Material besteht und zumindest ein optisches Element aufweist, mittels dessen Lichtstrahlen, die von dem Substrat ausgehend das zumindest eine optische Element durchlaufen, eine Brechung erfahren.

WO 2012/031703 A1 beschreibt ein Herstellungsverfahren für Chip-On-Board-Module, bei denen ein Substrat einen plattenförmigen Träger mit mehreren LEDs umfasst, wobei eine Oberfläche des Substrats in einer offenen Gießform überdeckend mit einer Schicht zur Ausbildung einer Optik versehen wird.

EP 2 317 205 A1 betrifft eine elektrisch leitfähige Hüllstruktur einer Beleuchtungsvorrichtung.

Es ist die Aufgabe der Erfindung ein optisches Modul anzugeben, das auf einfache Weise montierbar ist.

Diese Aufgabe wird erfindungsgemäß durch ein in den Ansprüchen 1-11 definiertes optisches Modul mit einer Haltevorrichtung gelöst, umfassend ein Substrat von definierter Form, wobei das Substrat zwei gegenüberliegende Oberflächen und einen Rand aufweist, und
eine auf zumindest einer der Oberflächen überdeckend aufgebrachte Schicht,
wobei die Schicht aus einem transparenten, polymeren Material besteht und zumindest ein optisches Element aufweist, mittels dessen Lichtstrahlen, die von dem Substrat ausgehend das zumindest eine optische Element durchlaufen, eine Brechung erfahren,
wobei in einem Randbereich der Schicht eine Ausformung zur Montage und/oder Justage des optischen Moduls vorgesehen ist, die materialeinheitlich einstückig mit der Schicht ausgebildet ist.

Unter einem optischen Modul im Sinne der Erfindung ist dabei jedes Bauteil zu verstehen, dass entweder aktiv Licht emittiert oder passiv ein Lichtbündel auf definierte Weise durch Brechung beeinflusst. Die Brechung erfolgt dabei zumindest teilweise durch das optische Element, das in der transparenten Schicht ausgeformt ist. Bei besonders bevorzugten Ausführungsformen kann es sich bei dem optischen Element insbesondere um eine Linse, zum Beispiel Sammellinse, Streulinse, Zylinderlinse, Fresnel-Linse oder Ähnliches handeln. Bei anderen Ausführungsformen kann die Brechung durch das optische Element aber auch in einer Streuung des Lichts, einer Aufspaltung durch ein Prisma oder Ähnlichem bestehen. Die polymere Schicht mit dem darin ausgeformten optischen Element bildet eine unmittelbar auf dem Substrat angeordnete Optik aus.

Unter einer Ausformung zur Montage und/oder Justage des Moduls wird im Sinne der Erfindung jede Strukturierung der Schicht verstanden, die unmittelbar zu einer Festlegung des Moduls, zum Beispiel durch Einklemmung der Struktur in einem Halter, dient oder die unmittelbar zu einer Positionierung des Moduls dient.

In vielen Fällen hat das Substrat eine plattenförmige Struktur. Diese kann zum Beispiel einen rechteckigen, kreisförmigen oder polygonalen Umfang haben. Bei solchen plattenförmigen Strukturen verlaufen die beiden Oberflächen parallel zueinander. Im Sinne der Erfindung liegt auch dann eine plattenförmige Struktur mit parallelen Oberflächen vor, wenn eine Oberfläche zum Beispiel aufgrund von aufgebrachten LEDs oder anderen Komponenten gewisse Unebenheiten aufweist.

Bei einer allgemein bevorzugten Ausführungsform der Erfindung ist es vorgesehen, dass das zumindest eine optische Element und die Ausformung zur Montage und/oder Justage in einem Gießvorgang im Zuge der Aufbringung der Schicht auf das Substrat materialeinheitlich einstückig mit der Schicht ausgeformt werden. Eine Herstellung einer solchen Schicht mit einem optischen Element in einem Gießvorgang beschreibt zum Beispiel WO 2012/031703 A1, auf die hiermit Bezug genommen wird. Die erfindungsgemäße zusätzliche Ausformung kann dabei durch entsprechende Modifizierung einer Gießform vorgenommen werden. Besonders bevorzugt erfolgt das Gießen dabei mittels eines Eintauchens des Substrats in eine offene Gießform, wie in WO 2012/031703 A1 beschrieben.

Bei einer bevorzugten Weiterbildung der Erfindung besteht die Schicht aus einem Silikon. Insbesondere kann es sich dabei um ein hochreines Silikon handeln, das eine hohe Beständigkeit gegen UV-Strahlung aufweist. Unter einem hochreinen Silikon ist ein Silikon zu verstehen, das weniger als 1 Promille, insbesondere weniger als 10 ppm Verunreinigungen und Fremdstoffe enthält. Hierunter fällt auch Kohlenstoff, der bei einem hochreinen Silikon im Sinne der Erfindung nicht enthalten ist.

Bei einer möglichen Ausführungsform der Erfindung umfasst die Ausformung zur Montage und/oder Justage des Moduls zumindest einen Vorsprung über eine Oberfläche der Schicht, wobei eine Klemmbacke einer Haltevorrichtung für das optische Modul auf dem Vorsprung aufliegt. Solche Vorsprünge dienen auf einfache Weise einer guten Halterung, wobei eine definierte Auflagefläche bereitgestellt wird. Hierdurch wird eine genaue Positionierung erreicht und zudem ein beschädigungsfreies Einklemmen ermöglicht. Die Dimensionierung der Vorsprünge können den Materialeigenschaften der polymeren Schicht wie Härte und Elastizität angepasst werden. Es kann sich zum Beispiel um Noppen, Wulste oder Ähnliches handeln. Die Größe der einzelnen Ausformungen kann typisch im Bereich 10 µm bis etwa 1 mm reichen, wenn das Modul zum Beispiel Seitenlängen in der Größenordnung von 1 cm bis 100 cm aufweist.

Bei einer Klemmung des Moduls über die Vorsprünge können diese auf definierte Weise durch die Klemmbacken gequetscht oder elastisch eingedrückt werden.

Bei einer hierzu alternativen oder auch ergänzenden Ausführungsform ist es vorgesehen, dass die Ausformung einen in einer Justagerichtung maßhaltig positionierenden Anschlag aufweist. Dies bedeutet insbesondere, dass durch die Schicht selbst die definierten Referenzpunkte bei positioniertem Einbau des Moduls gegeben sind. Dies bedeutet vorteilhaft auch, dass die räumliche Positionierung in der jeweiligen Justagerichtung definiert gegenüber der Position des optischen Moduls erfolgt. Die Positionierung des Substrates gegenüber der Schicht kann dabei innerhalb weiterer Toleranzen bestehen, die durch die jeweilige Anwendung definiert sind.

Bei einer vorteilhaften Detailgestaltung ist dabei eine Überdeckung des Randes des Substrats durch die Schicht ausgebildet, wobei die Justagerichtung zumindest annähernd parallel zu den Oberflächen des Substrats verläuft. Dies erlaubt die genaue Positionierung in einer zu der Abstrahlrichtung quer verlaufenden Raumrichtung, in der eine genaue Position des optischen Moduls oft besonders wichtig ist. Vorteilhaft beträgt die Genauigkeit einer Position des Anschlags in der Justagerichtung nicht mehr als 20 Promille, besonders bevorzugt nicht mehr als 5 Promille, einer Ausdehnung des optischen Moduls in der Justagerichtung. Falls das Material der polymeren Schicht relativ weich ist, ist vorteilhaft eine Kontrolle der Andruckkräfte bei der Montage zu beachten, um die genaue Anschlagposition nicht durch Kompression der Schicht zu verfälschen. Die Kombination eines maßhaltigen Anschlags mit der Herstellung des Moduls in einer insbesondere offenen Gießform ist besonders vorteilhaft, da solche Gießformen regelmäßig mit hoher Genauigkeit hergestellt werden. Entsprechend kann die Ausbildung einer Form für den genau positionierten Anschlag ohne großen Aufwand im Design der Gießform vorgesehen werden.

Bei einer weiteren, alternativen oder ergänzenden Ausführungsform der Erfindung ist die Ausformung zur Montage und/oder Justage zur in zumindest einer Richtung formschlüssigen Verkämmung mit einer Ausformung eines weiteren optischen Moduls ausgebildet. Dies ermöglicht ein unmittelbares Aneinanderfügen mehrerer Module in einer oder auch mehrerer Raumrichtungen. Durch die Formschlüssigkeit ist eine Halterung bzw. zumindest relative Positionierung in zumindest einer Raumrichtung gegeben. Zum Beispiel können in einer Längsrichtung seriell unmittelbar aneinander angeordnete Module positionierende Ausformungen nach Art von Nut und Feder aufweisen, die zumindest ein Verrutschen zueinander in einer Querrichtung verhindern. Die Ausformungen können aber auch eine formschlüssige Verkämmung in mehreren Raumrichtungen aufweisen, zum Beispiel Zapfen und Aufnahmen analog zur Gestaltung von Puzzleteilen. Je nach Anforderungen kann damit eine serielle oder flächige, positionierte Verbindung von unmittelbar aneinander grenzenden optischen Modulen geschaffen werden. Die Module können insbesondere jeweils baugleich sein.

Bei allgemein bevorzugten Ausführungsformen hat die Schicht eine Härte im Bereich von 10 bis 90 Shore A, besonders bevorzugt 50 bis 75 Shore A. Diese relativ geringe Härte ermöglicht den Einsatz von besonderen Polymeren als das optische Element formendes Medium, zum Beispiel hochreine Silikone. Der bevorzugte Härtebereich ist ausreichend, um bei Bedarf eine ausreichend genaue Positionierung und/oder Halterung über die Ausformungen der Schicht zu gewährleisten. Zum Beispiel bei einer klemmenden Halterung an erfindungsgemäßen Vorsprüngen kann in diesem Härtebereich eine weitgehend elastische Deformation der Vorsprünge vorliegen. Insgesamt liegt dabei eine gute Sicherung gegen Stöße, Vibrationen und/oder mechanische Spannung z.B. aufgrund thermischer Ausdehnungen vor.

Bei einer möglichen Ausführungsform der Erfindung umfasst das Substrat ein Chip-On-Board-Modul mit einem Träger und zumindest einer, auf dem Träger angeordneten LED. Solche Module sind zum Beispiel in der WO 2012/031703 A1 beschrieben.

Vorteilhaft liegen wenigstens 50% des von den LEDs emittierten Lichtes in einem Wellenlängenbereich von weniger als 470nm vor. Dies ermöglicht eine zumindest überwiegende Auslegung der Leuchte als UV-Strahler. Durch die weitere Kombination der erfindungsgemäßen Merkmale kann der UV-Strahler flexibel in einer technischen Vorrichtung, zum Beispiel einer Druckmaschine, eingebaut werden.

Alternativ hierzu liegen wenigstens 50% des von den LEDs emittierten Lichtes in einem Wellenlängenbereich von mehr als 780nm vor. Dies ermöglicht eine zumindest überwiegende Auslegung der Leuchte als IR-Strahler. Durch die weitere Kombination der erfindungsgemäßen Merkmale kann der IR-Strahler flexibel in einer technischen Vorrichtung, zum Beispiel einer Druckmaschine, eingebaut werden.

Bei einer anderen Ausführungsform umfasst das Substrat einen optisch durchlässigen oder optisch reflektierenden Träger, wobei durch den Träger und die Schicht insgesamt eine Optik zur gezielten Brechung von Lichtstrahlen ausgebildet ist. Solche Optiken werden bevorzugt wie in dem in WO 2012/031703 A1 beschriebenen Verfahren hergestellt, wobei das Chip-On-Board-Modul durch den optisch durchlässigen oder reflektierenden, also optisch wirksamen, Träger ersetzt ist. Der Träger kann auch auf zwei gegenüberliegenden Seiten mit einer polymeren Schicht und optischen Elementen überzogen sein. Je nach Anforderung kann jede der Schichten eine erfindungsgemäße Ausformung aufweisen. Ein einfaches Beispiel für einen Träger ist eine Glasplatte, auf der mittels der polymeren Schicht eine oder mehrere optische Elemente wie z.B. Linsen aufgebracht sind.

Die Aufgabe der Erfindung wird zudem durch eine Vorrichtung zum Trocknen einer Beschichtung gelöst, umfassend eine Leuchte mit einem erfindungsgemäßen optischen Modul. Das erfindungsgemäße Modul ist für eine solche Leuchte bzw. Vorrichtung besonders gut geeignet, da es hohe Bestrahlungsstärken mit flexibler und insbesondere kompakter Bauform kombiniert.

In bevorzugter Weiterbildung sind dabei ein flächiges Substrat mit der zu trocknenden Beschichtung und die Leuchte in einer Förderrichtung zueinander bewegbar, wobei die Leuchte in einer Querrichtung zumindest teilweise über eine Breite des Substrats erstreckt und in definiertem Abstand über dem Substrat angeordnet ist. Hierunter ist auch auch ein rasterndes Abfahren der Substratfläche in mehreren Bahnen zu verstehen. Zum Beispiel kann es sich bei dem Substrat um ein Druckerzeugnis handeln, das in einer Druckmaschine mit aufgedrucktem Lack oder einer anderen Substanz beschichtet wird.

Die Aufgabe der Erfindung wird zudem durch die Verwendung eines erfindungsgemäßen optischen Moduls zum Trocknen einer Beschichtung gelöst, bevorzugt in einem Druckverfahren.

Weitere Vorteile und Merkmale der Erfindung ergeben sich aus dem nachfolgend beschriebenen Ausführungsbeispiel sowie aus den abhängigen Ansprüchen.

Nachfolgend wird ein bevorzugtes Ausführungsbeispiel der Erfindung beschrieben und anhand der anliegenden Zeichnungen näher erläutert.
- Fig. 1: zeigt ein erfindungsgemäßes optisches Modul im Zuge des Einsetzens in eine Halterung.
- Fig. 2: zeigt das Element aus Fig. 1 in festgelegter Position zwischen Klemmbacken.

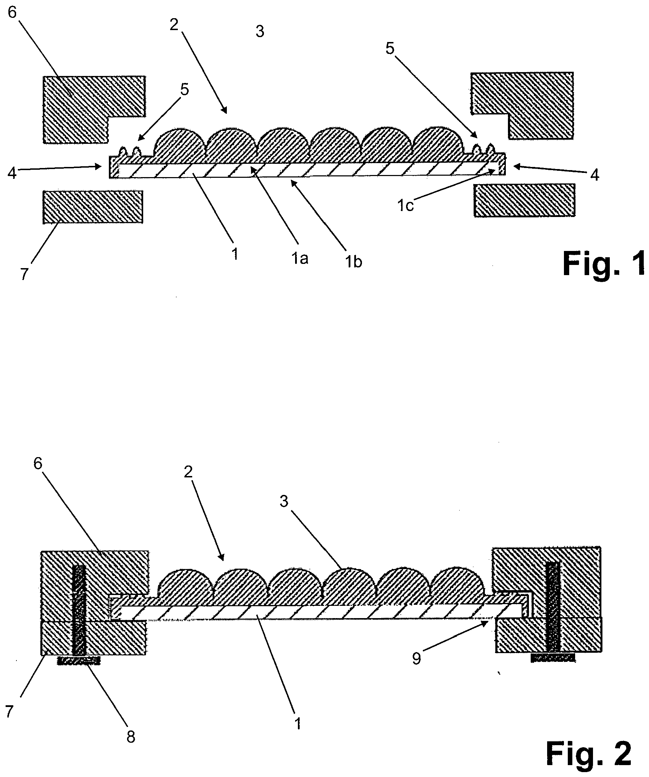

Das in Fig. 1 gezeigte optische Modul umfasst ein plattenförmiges Substrat' 1 bzw. einen Träger mit zwei parallelen Oberflächen 1a, 1b. Das Substrat hat vorliegend einen rechteckig geformten R and 1c. Das nur schematisch dargestellte Substrat 1 ist ein LED-Modul, bestückt mit einer Mehrzahl von in einem Raster angeordneten LEDs gemäß den in der WO 2012/031703 A1 beschriebenen Modulen. Solche Module werden auch als Chip-On-Board-Module bezeichnet und enthalten neben den LEDs auch Anschlussleitungen und gegebenenfalls weitere elektronische Bauelemente zur Ansteuerung der LEDs.

Der Träger ist mit einer aus hochreinem, UV-durchlässigem und UV-beständigem Silikon bestehenden Schicht 2 versehen. Die Schicht überdeckt eine der Oberflächen 1a. Die LEDs sind auf der Oberfläche 1a angeordnet, so dass die Oberfläche 1a nur annähernd eben ausgebildet ist. Im Sinne der Erfindung werden die beiden Oberflächen 1a, 1b aber als parallel angesehen.

Die Schicht ist materialeinheitlich einstückig ausgebildet und umfasst eine Mehrzahl von Ausformungen, die als optische Elemente 3, vorliegend als plankonvexe Sammellinsen, ausgebildet sind. Die Sammellinsen befinden sich jeweils über einer LED (nicht dargestellt), um deren abgestrahltes Licht zu bündeln bzw. um einen möglichst großen Öffnungswinkel des Lichtes zu transportieren.

Die Schicht 2 überdeckt auch den Rand 1c des plattenförmigen Substrats 1, so dass randseitige Außenflächen 4 des Moduls von der Schicht 2 ausgebildet werden. Durch die Außenflächen 4 sind zugleich genaue positionierte Anschläge ausgebildet, die eine Ausformung zur Justage des Moduls zumindest in einer Querrichtung erlauben. Die Querrichtung verläuft in der Horizontalen der Zeichnungsebene von Fig. 1. Die Position der Anschläge bzw. Außenflächen 4 in der Querrichtung ist auf weniger als 10 Promille eines Durchmessers des Moduls in der Querrichtung genau bestimmt. Insbesondere gilt diese Genauigkeit für eine Position der Anschläge relativ zu den Positionen der optischen Elemente 3.

Durch die Anschläge sind somit Ausformungen zur Justage und/oder Montage im Sinne der Erfindung ausgebildet.

Weitere erfindungsgemäße Ausformungen zur Justage und/oder Montage werden durch Vorsprünge 5 ausgebildet, die in einer Hochrichtung über die Oberfläche der Schicht 2 hervorragen. Die Vorsprünge sind im Bereich des Randes 1c über der Oberfläche 1a des Substrats vorgesehen. Sie umfassen je nach Anforderungen mehrere einzelne Noppen oder auch Stege.

Vorliegend sind beide Ausformungen 4, 5 in einem Montagebereich vorgesehen, der in der Nähe des Randes 1c des Trägers vorgesehen ist. Bei anderen Ausführungen kann der Montagebereich aber auch anders angeordnet sein, zum Beispiel um eine zentrale Bohrung oder Ähnliches.

Das optische Modul wird vorliegend mittels oberen Klemmbacken 6 und unteren Klemmbacken 7 klemmend in einer Vorrichtung gehalten. Die oberen Klemmbacken 6 drücken dabei nicht unmittelbar auf die freie, ebene Oberfläche der Schicht 2, sondern nur auf die Vorsprünge 5. Hierdurch ist eine definierte Halterung geschaffen, die mechanische, zum Beispiel durch Wärmeausdehnung bedingte Verspannungen gut ausgleichen kann.

Eine der oberen Klemmbacken 6 definiert vorliegend die Einbauposition bzw. genaue Ausrichtung des Moduls, so dass die korrespondierende Außenfläche 4 an einer entsprechenden Ausformung der oberen Klemmbacke 6 bzw. Halterung anliegt.

Die untere Klemmbacke 7 liegt an der unteren Oberfläche 1b des Substrats 1 an. Bei anderen Ausführungsformen kann aber auch die untere Oberfläche 1b des Substrats mit einer Schicht 2 überzogen sein, und auch an dieser Seite können erfindungsgemäße Ausformungen vorliegen. Im montierten Zustand gemäß Fig. 2 liegen die Klemmbacken 6, 7 aneinander an und sind durch eine Schraube 8 fixiert. Ein Befestigungsspalt 9 zwischen den Klemmbacken, in dem das Modul aufgenommen ist, ist in seiner Breite vorbestimmt, so dass keine Beschädigung des Moduls durch übermäßiges Anziehen eines Befestigungsgliedes erfolgen kann.

Die Schicht 2 besteht vorliegend aus einem Silikon mit einer Härte von etwa 50 Shore A. Da dies ein relativ weiches Material ist, ist die Einklemmung über die Vorsprünge besonders günstig, da hierdurch ein größerer elastischer Verzug der Schicht 2 und/oder der optischen Elemente 3 vermieden wird.

Die Herstellung des Moduls mit der Schicht 2 auf dem Substrat 1 erfolgt im Wesentlichen wie in WO 2012/031703 A1 beschrieben durch Eintauchen des Substrats in eine offene Gießform, die mit einem Silikon-Ausgangsmaterial gefüllt ist. Das Ausgangsmaterial ist niedrigviskos mit einer Viskosität von weniger als 1000 mPa*s, bevorzugt weniger als 100 mPa*s. Zusätzlich sind erfindungsgemäße Ausformungen zur Justage und/oder Montage an der Gießform vorgesehen.

Bei einem weiteren, nicht dargestellten Ausführungsbeispiel kann auf beiden Seiten des Substrats 1 eine Beschichtung erfolgen, insbesondere mittels desselben vorstehend beschriebenen Verfahrens. Insbesondere kann dabei das Substrat transparent ausgebildet sein, zum Beispiel als eine Glasplatte.

## Patentansprüche

1. Optisches Modul mit einer Haltevorrichtung, umfassend
ein Substrat (1) von definierter Form, wobei das Substrat zwei gegenüberliegende Oberflächen (1a, 1b) und einen Rand (1c) aufweist, und
eine auf zumindest einer der Oberflächen (1a, 1b) überdeckend aufgebrachte Schicht (2),
wobei die Schicht (2) aus einem transparenten, polymeren Material besteht und zumindest ein optisches Element (3) aufweist, mittels dessen Lichtstrahlen, die von dem Substrat (1) ausgehend das zumindest eine optische Element (3) durchlaufen, eine Brechung erfahren, wobei in einem Montagebereich der Schicht eine Ausformung zur Montage und/oder Justage des optischen Moduls vorgesehen ist, die materialeinheitlich einstückig mit der Schicht (2) ausgebildet ist, wobei
die Ausformung zur Montage und/oder Justage zumindest einen Vorsprung (5) über eine Oberfläche der Schicht (2) umfasst, **dadurch gekennzeichnet, dass** die Haltevorrichtung eine obere Klemmbacke (6) und eine untere Klemmbacke (7) umfasst und das optische Modul mittels oberer Klemmbacke (6) und unterer Klemmbacke (7) klemmend in der Haltevorrichtung gehalten ist, wobei die obere Klemmbacke (6) der Haltevorrichtung für das optische Modul auf dem zumindest einen Vorsprung (5) aufliegt.

2. Optisches Modul nach Anspruch 1, **dadurch gekennzeichnet, dass** das zumindest eine optische Element (3) und die Ausformung zur Montage und/oder Justage in einem Gießvorgang im Zuge der Aufbringung der Schicht (2) auf das Substrat materialeinheitlich einstückig mit der Schicht (2) ausgeformt werden.

3. Optisches Modul nach Anspruch 2, **dadurch gekennzeichnet, dass** der Gießvorgang ein Eintauchen des Substrats in eine offene Gießform umfasst.

4. Optisches Modul nach einem der Ansprüche 2 oder 3, **dadurch gekennzeichnet, dass** die Schicht (2) aus einem Silikon besteht.

5. Optisches Modul nach einem der vorhergehenden Ansprüche, **dadurch gekennzeichnet, dass** die Ausformung zur Montage und/oder Justage einen in einer Justagerichtung maßhaltig positionierenden Anschlag aufweist.

6. Optisches Modul nach Anspruch 5, **dadurch gekennzeichnet, dass** der Anschlag an einer Überdeckung des Randes (1c) des Substrats durch die Schicht (2) ausgebildet ist, wobei die Justagerichtung zumindest annähernd parallel zu den Oberflächen des Substrats verläuft.

7. Optisches Modul nach Anspruch 5 oder 6, **dadurch gekennzeichnet**, das die Genauigkeit einer Position des Anschlags in der Justagerichtung nicht mehr als 20 Promille einer Ausdehnung des optischen Moduls in der Justagerichtung beträgt.

8. Optisches Modul nach einem der vorhergehenden Ansprüche, **dadurch gekennzeichnet, dass** die Ausformung zur Montage und/oder Justage zur in zumindest einer Richtung formschlüssigen Verkämmung mit einer Ausformung eines weiteren optischen Moduls ausgebildet ist.

9. Optisches Modul nach einem der vorhergehenden Ansprüche, **dadurch gekennzeichnet, dass** die Schicht eine Härte im Bereich von 10 bis 90 Shore A aufweist.

10. Optisches Modul nach einem der vorhergehenden Ansprüche **dadurch gekennzeichnet, dass** das Substrat (1) ein Chip-On-Board-Modul mit einem Träger und zumindest einer auf dem Träger angeordneten LED umfasst.

11. Optisches Modul nach einem der Ansprüche 1 bis 9, **dadurch gekennzeichnet, dass** das Substrat (1) einen optisch durchlässigen oder optisch reflektierenden Träger umfasst,
wobei durch den Träger und die Schicht (2) insgesamt eine Optik zur gezielten Brechung von Lichtstrahlen ausgebildet ist.

12. Vorrichtung zum Trocknen einer Beschichtung, umfassend eine Leuchte mit einem optischen Modul nach einem der vorhergehenden Ansprüche.

13. Vorrichtung nach Anspruch 12, **dadurch gekennzeichnet, dass** ein flächiges Substrat mit der zu trocknenden Beschichtung und die Leuchte in einer Förderrichtung zueinander bewegbar sind, wobei die Leuchte in einer Querrichtung zumindest teilweise über eine Breite des Substrats erstreckt und in definiertem Abstand über dem Substrat angeordnet ist.

14. Verwendung eines optischen Moduls nach einem der Ansprüche 1 bis 11 zum Trocknen einer Beschichtung, insbesondere in einem Druckverfahren.

## Claims

1. An optical module with a holding device, comprising
a substrate (1) of a defined shape, wherein the substrate has two opposite surfaces (1a, 1b) and an edge (1c), and
a layer (2) applied to cover at least one of the surfaces (1a, 1b),
wherein the layer (2) consists of a transparent, polymeric material and has at least one optical element (3), by means of which light beams are refracted, which originate from the substrate (1) and pass through the at least one optical element (3), wherein in an installation area of the layer there is provided a moulded portion for installation and/or adjustment of the optical module, which is formed in one piece with the layer (2) and consisting of the same material, wherein
the moulded portion for installation and/or adjustment comprises at least one projection (5) projecting beyond a surface of the layer (2), **characterised in that** the holding device comprises an upper clamping jaw (6) and a lower clamping jaw (7), and the optical module is held in a clamped manner in the holding device by means of upper clamping jaw (6) and lower clamping jaw (7), wherein the upper clamping jaw (6) of the holding device for the optical module bears on the at least one projection (5).

2. The optical module according to claim 1, **characterised in that** the at least one optical element (3) and the moulded portion for installation and/or adjustment are formed in casting process during the application of the layer (2) onto the substrate in one piece with the layer (2) and consisting of the same material.

3. The optical module according to claim 2, **characterised in that** the casting process comprises an immersion of the substrate into an open casting mould.

4. The optical module according to any one of claims 2 or 3, **characterised in that** the layer (2) consists of a silicon.

5. The optical module according to any one of the preceding claims, **characterised in that** the moulded portion for installation and/or adjustment has a stop which positions in a dimensionally stable manner in an adjusting direction.

6. The optical module according to claim 5, **characterised in that** the stop is formed by the layer (2) at a coverage of the edge (1c) of the substrate, wherein the adjusting direction runs at least approximately parallel to the surfaces of the substrate.

7. The optical module according to claim 5 or 6, **characterised in that** the accuracy of a position of the stop in the adjusting direction is no more than 20 parts per thousand of an expansion of the optical module in the adjusting direction.

8. The optical module according to any one of the preceding claims, **characterised in that** the moulded portion for installation and/or adjustment is formed for jamming in a form-fitting manner in at least one direction with a moulded portion of a further optical module.

9. The optical module according to any one of the preceding claims, **characterised in that** the layer has a hardness in the range of between 10 and 90 Shore A.

10. The optical module according to any one of the preceding claims, **characterised in that** the substrate (1) comprises a chip-on-board module comprising a carrier and at least one LED arranged on the carrier.

11. The optical module according to any one of claims 1 to 9, **characterised in that** the substrate (1) comprises an optically transparent or optically reflective carrier, wherein an optical system for the systematic refraction of light beams is formed by the carrier and the layer (2) as a whole.

12. A device for drying a coating, comprising a lamp with an optical module according to any one of the preceding claims.

13. The device according to claim 12, **characterised in that** a flat substrate with the coating to be dried and the lamp can be moved toward one another in a conveying direction, wherein the lamp extends at least partially over a width of the substrate in a transverse direction and is arranged at a defined distance above the substrate.

14. Use of an optical module according to any one of claims 1 to 11 for drying a coating, in particular in a printing process.

## Revendications

1. Module optique avec un dispositif de maintien comprenant un substrat (1) de forme définie, dans lequel le substrat présente deux surfaces opposées (1a, 1b) et un bord (1c), et
une couche (2) appliquée sur au moins une des surfaces (1a, 1b) en la recouvrant,
dans lequel la couche (2) se compose d'un matériau polymère transparent et présente au moins un élément optique (3) au moyen duquel des rayons lumineux qui traversent l'au moins un élément optique (3) en partant du substrat (1) subissent une réfraction, dans lequel une formation pour le montage et/ou l'alignement du module optique qui est réalisée d'une pièce avec la couche (2) de manière uniforme en termes de matériau est prévue dans une région de montage de la couche, dans lequel
la formation pour le montage et/ou l'alignement comprend au moins une saillie (5) au-dessus d'une surface de la couche (2), **caractérisé en ce que** le dispositif de maintien comprend une mâchoire de serrage supérieure (6) et une mâchoire de serrage inférieure (7), et le module optique est maintenu dans le dispositif de maintien en serrant au moyen de la mâchoire de serrage supérieure (6) et la mâchoire de serrage inférieure (7), dans lequel la mâchoire de serrage supérieure (6) du dispositif de maintien pour le module optique repose sur l'au moins une saillie (5).

2. Module optique selon la revendication 1, **caractérisé en ce que** l'au moins un élément optique (3) et la formation pour le montage et/ou l'alignement sont formés d'une pièce avec la couche (2) de manière uniforme en termes de matériau dans un processus de coulée au cours de l'application de la couche (2) sur le substrat.

3. Module optique selon la revendication 2, **caractérisé en ce que** le processus de coulée comprend une immersion du substrat dans un moule de coulée ouvert.

4. Module optique selon une des revendications 2 ou 3, **caractérisé en ce que** la couche (2) se compose d'une silicone.

5. Module optique selon une des revendications précédentes, **caractérisé en ce que** la formation pour le montage et/ou l'alignement présente une butée se positionnant à dimensions exactes dans une direction d'alignement.

6. Module optique selon la revendication 5, **caractérisé en ce que** la butée est réalisée au niveau d'un recouvrement du bord (1c) du substrat par la couche (2), dans lequel la direction d'alignement s'étend au moins approximativement parallèlement aux surfaces du substrat.

7. Module optique selon la revendication 5 ou 6, **caractérisé en ce que** la précision d'une position de la butée dans la direction d'alignement ne se monte pas à plus de 20 pour mille d'une extension du module optique dans la direction d'alignement.

8. Module optique selon une des revendications précédentes, **caractérisé en ce que** la formation pour le montage et/ou l'alignement est réalisée pour l'engrenage par conjugaison de formes dans au moins une direction avec une formation d'un autre module optique.

9. Module optique selon une des revendications précédentes, **caractérisé en ce que** la couche présente une dureté dans la région de 10 à 90 Shore A.

10. Module optique selon une des revendications précédentes, **caractérisé en ce que** le substrat (1) comprend un module de montage direct des puces avec un support et au moins une LED disposée sur le support.

11. Module optique selon une des revendications 1 à 9, **caractérisé en ce que** le substrat (1) comprend un support transparent du point de vue optique ou réfléchissant du point de vue optique, dans lequel une optique pour la réfraction ciblée de rayons lumineux est réalisée à travers le support et la couche (2) en entier.

12. Dispositif de séchage d'un revêtement, comprenant une lampe avec un module optique selon une des revendications précédentes.

13. Dispositif selon la revendication 12, **caractérisé en ce qu'**un substrat plan avec le revêtement à sécher et la lampe peuvent être déplacés l'un vers l'autre dans une direction de transport, dans lequel la lampe s'étend dans une direction transversale au moins partiellement sur une largeur du substrat et est disposée à une distance définie au-dessus du substrat.

14. Utilisation d'un module optique selon une des revendications 1 à 11 pour le séchage d'un revêtement, notamment dans un procédé d'impression.
